Europäisches Patentamt

European Patent Office

Office européen des brevets

(11) Publication number: **0 278 391**
**A2**

# EUROPEAN PATENT APPLICATION

(21) Application number: 88101597.8

(51) Int. Cl.⁴: **G11C 7/00**

(22) Date of filing: 04.02.88

(30) Priority: 07.02.87 GB 8702785

(43) Date of publication of application:
**17.08.88 Bulletin 88/33**

(84) Designated Contracting States:
**DE FR GB**

(71) Applicant: MOTOROLA INC.
Motorola Center 1303 Algonquin Rd.
Schaumburg Illinois 60196(US)

(72) Inventor: Guillot, Pierre
Avenue Gaspard Vallette, 14
CH-1206 Geneva(CH)

(74) Representative: Hudson, Peter David et al
Motorola Patent and Licensing Operations -
Europe Jays Close Viables Industrial Estate
Basingstoke Hampshire RG22 4PD(GB)

(54) Memory system.

(57) A memory system comprising a plurality of first memory cells (8) each having a structure which produces inversion of a written binary value upon reading, is characterized in that the memory system further comprises: a second memory cell (22) having a structure which produces inversion of a written binary value upon reading; and interface logic means (24) for logically combining a value read from the second memory cell with values read from the first memory cells.

If the second memory cell (22) is written to or read from each time the first memory cells are written to or read from respectively, and if the second memory cell is written to with the value last read from it, the value read from the second memory cell will always reflect the inversion state of the values read from the first memory cells and so the interface logic means (24) will accurately reproduce the values written to the first memory cells.

## Memory System

This invention relates to memory sytems.

In designing a memory cell structure for a memory system, an otherwise-desirable simple cell structure is often not utilised because such a simple cell structure would produce inversion of a written binary value upon reading.

In order to avoid this problem it has been considered necessary to use a more complicated form of cell structure which is not subject to such inversion, even though the more complicated cell structures may require greater semiconductor area and consume more power.

It is an object of the present invention to provide a memory system in which this difficulty may be obviated, allowing the use of simple memory cell structures.

In accordance with the present invention a memory system comprising a plurality of first memory cells each having a structure which produces inversion of a written binary value upon reading, is characterized in that the memory system further comprises:

a second memory cell having a structure which produces inversion of a written binary value upon reading; and

interface logic means for logically combining a value read from the second memory cell with values read from the first memory cells.

Thus, it will be understood, if the second memory cell is written to or read from each time the first memory cells are written to or read from respectively, and if the second memory cell is written to with the value last read from it, the value read from the second memory cell will always reflect the inversion state of the values read from the first memory cells and so the interface logic means will accurately reproduce the values written to the first memory cells.

Preferably the first memory cells and the second memory cell are EEPROM cells.

Preferably the first memory cells and the second memory cell each comprise a first non-volatile field effect transistor for holding the contents of the cell, a second field effect transistor having a first current electrode coupled to a first input of the cell and a second current coupled to a first current electrode of the first transistor, and a third transistor having a first current electrode coupled to a second input of the cell and a second current electrode coupled to the gate electrode of the first transistor.

Preferably the memory system comprises a plurality of non-volatile groups of first and second memory cells and a group of volatile memory cells.

One memory system in accordance with the present invention combining static cells RAM with EEPROM non-volatile memory will now be described, by way of example only, with reference to the accompanying drawings, in which:

Figure 1 is a schematic diagram showing the circuit of part of the memory system;

Figure 2 is a diagram illustrating the operation of the memory system in accordance with the invention: and

Figure 3 is a schematic diagram showing the interface circuitry of the memory system.

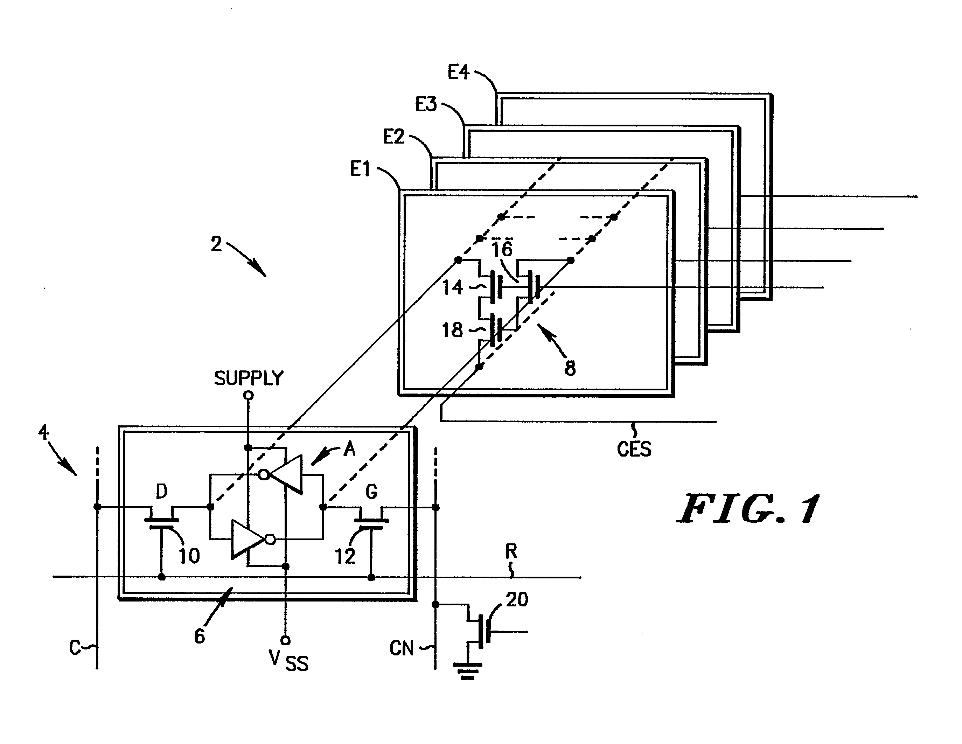

Referring firstly to Figure 1, the memory system 2 has a single plane 4 of static RAM memory having n x m identical cells, only one of which 6 is shown. Associated with the plane 4 of static RAM memory are four planes of EEPROM non-volatile memory E1, E2, E3, E4 each having n x m identical cells, only one of which 8 is shown.

The memory system is arranged so that each cell in the plane 4 has a unique counterpart in each of the four EEPROM planes E1, E2, E3, E4. Each of the EEPROM planes holds a different program and/or data which is transferred between EEPROM plane and RAM plane as necessary. A memory system operating in this manner is more fully described in the present applicant's copending U.K. patent application entitled "NON-VOLATILE MEMORY SYSTEM", having applicant's reference SCO033EG and filed on the same date as the present application; this copending application is hereby incorporated herein by reference.

The static RAM cell 6 includes two field effect transistors (FETs) 10, 12 having their current electrodes coupled in series between a pair of split column select lines C, CN. The gate electrodes of the FETs 10, 12 are connected to a row select line R, and an inverting buffer amplifier arrangement A is connected between the FETs 10, 12 and supplied from a supply line (normally at voltage Vdd) and a line at datum potential Vss. Such a static RAM cell structure is well known in the art.

The EEPROM cell 8 includes first and second FETs 14, 16 having first current electrodes connected respectively to drain and source electrodes of the cell. A third EEPROM FET 18 has a first current electrode connected to an EEPROM source line CES common to EEPROM cell 8 and its counterpart EEPEOM cells in planes E2, E3 amd E4, and a second current electrode connected to the second current electrode of first FET 14. Second FET 16 has its second current electrode connected to the gate electrode of the EEPROM FET 18, and the gate electrodes of the first and second FETs 14, 16 are connected to a plane select line common to all EEPROM cells in the same plane.

The nodes D and G of each static RAM cell 6 are connected respectively to the drain and source electrodes of its counterpart EEPROM cells in the planes E1, E2, E3, E4.

In use of the memory system, to transfer program and/or data from one of the non-volatile EEPROM planes to the volatile RAM plane 4 the static RAM cells 6 are preset via a transistor 20 on each cell's column select line CN so that the cell's node D is at a potential Vdd and the cell's node G is at a potential Vss. The common EEPROM source line CES is pulled to the voltage Vss and a selected one of the page select lines is pulled high. Thus potential Vss is applied to the gate electrode of the EEPROM cell to be transferred. If the EEPROM transistor 18 of this cell is erased (off), nothing will happen and the static RAM cell 6 will remain in its previous state. If the EEPROM transistor 18 of this cell is written (on), selecting the EEPROM plane and pulling the EEPROM common source line CES to potential Vss will bring node D of the static RAM cell 6 to potential Vss and node G of the cell to potential Vdd.

Thus the data in the static RAM cell 6 after a recall operation will represent the state of the counterpart FET in the selected EEPROM plane: node D will be at potential Vss if the EEPROM FET was written, or node D will be at potential Vdd if the EEPROM FET was erased. The recall operation is ended by deselecting the relevant page select line to potential Vss.

To transfer program and/or data from the volatile RAM plane 4 to one of the non-volatile EEPROM planes requires a high voltage to write or erase the EEPROM transistors. A write operation requires a potential Vpp on the drain electrode and the potential Vss on the source electrode of the appropriate EEPROM transistor 18. An erase operation requires the potential Vss on the drain electrode and the potential Vpp on the source electrode of the transistor. A store operation is effected by allowing the EEPROM common source line CES to float, applying potential Vpp to select the appropriate EEPROM plane and raising the potential at the supply line of the cell 6 from Vdd to Vpp. In this way the high voltage data will be applied from the static RAM cell 6 directly to the EEPROM transistor 18 which will be written or erased according to the static RAM cell content. The store operation is ended by pulling the supply line from potential Vpp to Vdd and deselecting the relevant page select line to potential Vss so as to isolate the volatile and non-volatile memory planes.

However, it will be understood that during a store operation a binary '1' (potential Vdd) at node D of a static RAM cell 6 produces a write of the selected counterpart EEPROM transistor 18. If subsequently a recall operation is performed from this EEPROM transistor the node D previously at potential Vdd will be pulled to potential Vss because of the 'on' state of the EEPROM transistor, signifying a binary '0'. The converse occurs if the store operation is performed with a digital '0' (potential Vss) at node D: after a subsequent recall it becomes a binary '1' (potential Vdd).

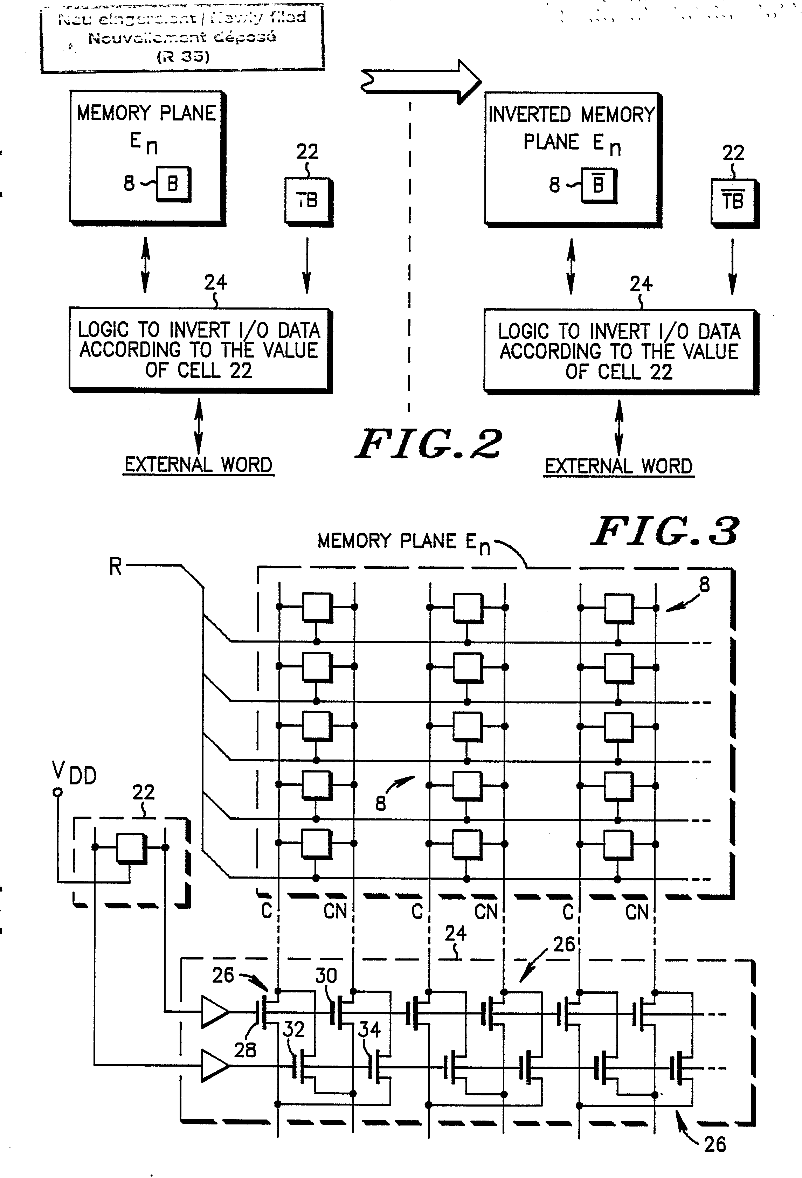

Referring now also to Figure 2, in order to circumvent this problem while retaining the simple structure of EEPROM cell 8, an EEPROM 'toggle' cell 22 is used to hold a marker of the inversion state of the value read from the EEPROM planes E1, E2, E3, E4, and interface logic 24 is used to invert I/O data in dependence upon the state of the contents of the 'toggle' cell 22.

The 'toggle' cell 22 is provided as one of the EEPROM cells 8 in each of the EEPROM planes E1, E2, E3, E4. Thus each time that a recall and store cycle is performed, the binary value of the 'toggle' cell 22 in an EEPROM plane is recalled and stored and so is inverted (along with the values of all the other cells in the same EEPROM plane). Thus the content of each 'toggle' cell 22 always reflects the inversion state of the values held in the cells of its EEPROM plane.

Referring now also to Figure 3, the binary value held in the 'toggle' cell 22 of the currently selected EEPROM plane is used to drive the interface logic circuitry 24 so as always to present the true values to the real world. The interface logic circuitry 24 comprises a number of sets of four FETs 26. The first and second FETs 28, 30 of each set have their current electrodes respectively connected in series in the column select lines C and CN of the non-volatile RAM plane 4, the third FET 32 of each set has its current electrodes connected between the source electrode of the first transistor 28 and the drain electrode of the second transistor 30, and the fourth FET 34 of each set has its current electrodes connected between the drain electrode of the first transistor 28 and the source electrode of the second transistor 30. The gate electrodes of all of the first and second transistors 28, 30 are connected via line buffer 36 to a first column select line of the 'toggle' cell 22, and the gate electrodes of all of the third and fourth transistors 32, 34 are connected via line buffer 38 to a second column select line of the 'toggle' cell 22.

It will be appreciated that in the above described memory system the solution employed to the inversion produced by the simple EEPROM memory cell structure is itself simple, and produces a number of advantages, including the following:

The 'toggle' cell 22 is a standard EEPROM memory cell so no extra design is needed.

The interface logic circuitry 24 is easily implemented between the memory array and the I/O sense amplifiers.

The solution does not require any pre-setting or pre-knowledge of the initial value of the contents of the 'toggle' cell in order to operate correctly after start up. This is because the extra 'toggle' cell 22 is subjected to the same signals and operations as the rest of the memory plane. At the beginning the 'toggle' cell assumes a random value, as do all the cells of the memory plane. As soon as a value is loaded into the memory, the 'toggle' bit acqures a signnification associated with the state of the data latched (inverted or non-inverted). Thereafter, any operation inverting the data will also invert the 'toggle' bit which will compensate in retrieving the correct data. As long as there is significant data in the static RAM, the 'toggle' bit will have a significant value for that data.

## Claims

1. A memory system (2)comprising a plurality of first memory cells (8) each having a structure which produces inversion of a written binary value upon reading, is characterized in that the memory system (2) further comprises:

a second memory cell (22) having a structure which produces inversion of a written binary value upon reading; and

interface logic means (24) for logically combining a value read from the second memory cell (22) with values read from the first memory cells (8).

2. A memory system (2) according to claim 1 wherein the first memory cells (8) and the second memory cell (22) are EEPROM cells.

3. A memory system (2) according to claim 1 or 2 wherein the first memory cells (8) and the second memory cell (22) each comprise a first non-volatile field effect transistor (14) for holding the contents of the cell, a third field effect transistor (18) having a first current electrode coupled to a first input of the cell and a second current coupled to a first current electrode of the first transistor (14), and a second transistor (16) having a first current electrode coupled to a second input of the cell and a second current electrode coupled to the gate electrode of the third transistor (18).

4. A memory system (2) according to claim 1, 2 or 3 wherein the memory system comprises a plurality of non-volatile groups of said first and said second memory cells and a group of volatile memory cells (6).

0 278 391

E4

E3

E2

E1

2

16

14

18

8

SUPPLY

A

CES

4

D

G

10

12

6

R

20

C

CN

V SS

*FIG.1*

MEMORY PLANE
$E_n$

$8 \sim \boxed{B}$

22

$\boxed{TB}$

24

LOGIC TO INVERT I/O DATA
ACCORDING TO THE VALUE
OF CELL 22

EXTERNAL WORD

INVERTED MEMORY
PLANE $E_n$

$8 \sim \boxed{\bar{B}}$

22

$\boxed{\overline{TB}}$

24

LOGIC TO INVERT I/O DATA
ACCORDING TO THE VALUE
OF CELL 22

EXTERNAL WORD

*FIG.2*

*FIG.3*

MEMORY PLANE $E_n$

R

8

$V_{DD}$

22

8

C    CN    C    CN    C    CN

24

26

26    30    32    34

28

26